# EUROPEAN PATENT SPECIFICATION

(11) **EP 2 181 469 B1**
(45) Date of publication and mention of the grant of the patent: **07.11.2012**
(21) Application number: 08806875.4
(22) Date of filing: 31.07.2008
(51) Int. Cl.: H01M 2/20, H01M 10/42, H01M 10/48

(54) **STORAGE BATTERY ASSEMBLY**
SPEICHERBATTERIEANORDNUNG
ENSEMBLE BATTERIE D'ACCUMULATEURS

(30) Priority: 02.08.2007 DE 102007036595; 13.08.2007 DE 102007038252; 26.10.2007 DE 102007051689; 01.12.2007 DE 102007058179; 21.12.2007 DE 102007062806; 22.12.2007 DE 102007062612
(43) Date of publication of application: 05.05.2010
(73) Proprietor: Johnson Controls Saft Advanced Power Solutions LLC, Wilmington, DE 53209-4409 (US)
(72) Inventor: MUIS, Pascal, F-95300 Pontoise (FR)
(74) Representative: Günther, Constantin
(86) International application number: PCT/IB2008/002011
(87) International publication number: WO 2009/016491

(56) References cited:
- WO-A-2006/099602
- FR-A- 2 748 608
- GB-A- 2 330 251
- US-A1- 2002 022 178

## Description

The present invention relates to a storage battery assembly for vehicles comprising:
- a plurality of battery cells, each battery cell comprising a closed cell housing and at least one cell terminal extending from the cell housing,
- electric conductive bars mounted on dedicated cell terminals, said conductive bars electrically connecting battery cells, and
- at least one circuit board comprising electronic circuitry provided for monitoring and/or controlling of battery cells.

Storage battery assemblies are widely used for power supply of electronic devices and are of main importance for hybrid vehicles. Hybrid vehicles requires high sophisticated cell arrangements in view of cooling the storage battery and control of the cells. Therefore, control units are provided for a set of cells comprising at least one of a temperature sensor, a voltage sensor and a current sensor for monitoring the status of a set of cells.

A storage battery assembly for vehicles comprises a high number of battery cells which have to be mounted and connected together in a housing by use of conductive bars. This is time consuming and causes high costs of manufacturing. Moreover, the electronic circuitry provided for monitoring and/or controlling of single battery cells or a group of battery cells has to be connected to cell terminals or conductive bars. Again, establishing the connections is time consuming. Further, due to the wide temperature range in a battery housing and due to high vibrational load of the storage battery assembly, a very stable design of the connections is required.

DE 10 2005 055 418 B3 discloses, for example, a storage battery assembly comprising a plurality of prismatic battery cells connected one to each other by use of terminals extending to a battery cell housing and carrying an U-formed connection plate. An adjacent battery cell is plugged into the U-formed connection plate and is welded with its housing providing the negative pole to the connection plate.

DE 100 11 233 B4 discloses a battery pack comprising temperature sensors located on a row of battery cells for measuring the temperature of the battery cells.

DE 10 2004 043 138 A1 discloses a battery, cover comprising integrated contact portions for connecting to the battery terminals and comprising electronic circuitry. The battery cover can be placed on top of a battery comprising a plurality of battery cells and is intended for use with a starter battery.

EP 1 250 720 B1 discloses a battery cell comprising a battery cell housing and electronic circuitry incorporated into the battery cell housing. A battery cell terminal is connected to the electronic circuitry by use of a spring contact member. The electrodes inside the battery cell housing are connected to a contact plate at the bottom side of the circuit board comprising the electronic circuitry.

US 2006/0091891 A1 discloses a battery assembly comprising a plurality of prismatic battery cells and bus bars on the top of the cell assembly for connecting adjacent battery cell terminals. Temperature measurement members are attached to the bus bars. A printed circuit board made of a thin cupper laminate is connected to the bus bar. A circuit is printed at the printed circuit board to which electric current is transmitted from the bus bar via protrusions and electric current is transmitted from a thermistor via through holes. The printed circuit board is connected to a battery management system, at which a voltage measuring device and a temperature measuring device are mounted.

KR 10 2004 0005066 A discloses a device for connecting battery cells of hybrid electric vehicles comprising a printed circuit board equipped with an electrical circuit for serial or parallel connection of the cells of a battery. The printed circuit board is electrically connected to each of cells to connect cells in a serial or parallel. A voltage measurement connection socket is connected to the electrical circuit of the printed circuit board and a cell voltage measurement unit.

GB 2 375 223 A discloses a battery management system comprising a printed circuit board and a plurality of electrochemical cells. The printed circuit board is plugged onto cell terminals protruding from the battery cell housing and screwed onto the Battery terminals by nuts. The printed circuit board carries hardware and software components in a number of sensors for monitoring and controlling the battery pack. Further, the printed circuit board carries tracks for connecting a pair of cell terminals respectively. Thus, a connection of battery cells serial or parallel and a connection of battery terminals to electronic circuitry for monitoring and controlling battery cells is achieved in one step simply by screwing the printed circuit board onto the cell terminals.

DE 10 2006 002 457 A1 discloses an electrical connector between a printed circuit board and a battery terminal. An electric conductive bushing mounted in a hole of the printed circuit board is plugged and welded onto a battery terminal pose.

US 7,028,389 B2 discloses a fixing device for a printed circuit board comprising an elastic washer mounted between the printed circuit board and a fixing pillar. Electric current is able to flow from conductive lines on the printed circuit board through the elastic washer and the fixing pillar to a shell.

DE 203 20 473 U1 discloses a shunt provided in a plate like connector element for cell terminals.

US 2002/0022178 is directed to a cell module structure having a bus bar plate and plural cylindrical cells. The bus bar plate includes plural bus bars each having a positive bus bar terminal, a negative bus bar terminal, and a screw formed in one of the terminals. The bus bars are serially connected to each other with the positive bus bar terminal corresponding to the negative bus bar terminal, A control substrate is integrally provided to the bus bar and connected to the bus bars.

In view of this prior art, the object of the present invention is to improve a storage battery assembly and to allow cheap interconnection of a cell board and cell terminals and easy and reliable interconnection of cell terminals to each other by use of conductive bars.

The object is achieved with a storage battery assembly for vehicles comprising:
- a plurality of battery cells, each battery cell comprising a closed cell housing and at least one cell terminal extending from the cell housing,
- electric conductive bars mounted on dedicated cell terminals, said conductive bars electrically connecting battery cells and
- at least one circuit board comprising an electric circuitry provided for monitoring and/or controlling of battery cells,
- cell terminal are carrying electrically conductive interconnection washers mounted thereon, wherein said interconnection washers extending to a dedicated circuit board and being connected with electronic circuitry on said respective circuit board, and wherein said circuit board connected to at least one interconnection washer being located adjacent to the at least one cell terminal to which the at least one interconnection washer is connected,
- wherein at least one of the circuit boards is located among a respective battery cell housing and conductive bars.

According to the present invention, electric conductive bars are mounted on dedicated cell terminals independent from the at least one circuit board. The at least one circuit board is connected to dedicated cell terminals by use of interconnection washers, Said interconnection washer has the advantage, that the connection of a cell terminal and a circuit board can be made close to the cell terminal. Further, the washer can be mounted onto the cell terminal together with the bus bar.

The at least one interconnection washer is preferably elastic, so that the washer and the connection between the circuit board and the battery terminal by use of the washer stands high vibrational load.

Since at least one of the circuit boards is located between the respective battery cell housing and conductive bars, the intermediate space between the battery cell housing and the conductive bars are used to place the circuit boards. The advantage of this design is, that the circuit board can be fastened in the gap between the cell housing and the conductive bare by the conductive bars itself. The contact between the battery cell terminals and the circuit boards is established by use of the interconnection washers, which are also securely fastened by the conductive bars mounted to the battery terminals.

In order to avoid short circuits especially when using electric conductive cell housings, an insulation layer should be provided between the circuit board and the adjacent cell housing and/or an adjacent conductive bar. The insulation layer can be made as integral part of the printed circuit board.

In a preferred embodiment, at least one of the circuit boards are comprising holes corresponding to the location of the cell terminals. Said circuit boards are located on battery cells with the cell terminals extending through respective holes of the circuit board. Thus, when mounting a storage battery assembly, first circuit boards are plugged into the cell terminals with the interconnection washers extending from the printed circuit board to the respective battery cell terminals. Second, the conductive bars are fastened to respective battery cell terminals, whereby electrically connecting adjacent battery cells and dedicating washers and establishing an electrical conductive connection of battery cell terminals and interconnection washers.

Advantageously, at least one of the circuit boards is placed on top of the at least one of the cell housings with the cell terminals extending over the at least one circuit board. The interconnection washers are mounted to said extending cell terminals having elastic legs of a height being greater than the gap between the upper surface of a circuit board to which the interconnection washer is connected and the connection between the interconnection washer and the respective cell terminal. Said elastic legs being spring biased to the circuit board when connecting the respective interconnection washer to the dedicated cell terminal.

By use of the elastic legs of the interconnection washers having a height being greater than the gap between the upper surface of the circuit board in the connection, a spring biased contact of the washer to the printed circuit board is achieved, which can stand high vibrational load.

Further, it is of advantage when at least one of the circuit boards is flexible.

At least one of the interconnection washer can be welded or soldered to a conductor path on a dedicated circuit board. Soldering or welding the interconnecting washer to the dedicated conductor path on the circuit board has the advantage over a press contact to be more reliable. Further, the interconnection washer can be welded or soldered to the printed circuit board before mounting the printed circuit board onto the battery cell assembly. Thus, the printed circuit board can be assembled in one step to the battery cells. In a next step, the conductive bars are installed on the battery cell terminals, thereby fastening the washers to the cell terminals.

In another preferred embodiment, the interconnection washers are placed on top of a free end of a dedicated cell terminal. The conductive bars are placed on top of a respective interconnection washer. Said cell terminals are comprising internal threads and said interconnection washers and conductive bars comprising respective openings. A cell terminal, an interconnection washer and a conductive bar are mounted together by a screw extending through the openings of the conductive bar and the interconnection washer and screwed into the internal thread of the cell terminal. The use of the internal thread in the cell terminal has the advantage, that cell terminal, interconnection washer and conductive bar can be mounted together in one step providing a high reliable electrical and mechanical connection, which can stand high vibrational load.

In another preferred embodiment, at least one of the interconnection washer is formed by a metal cap comprising a base plate, a side wall circumferential surrounding the base plate and a foot plate extending from the side wall to the outside at the lower edge of the opposite side of the base plate forming a rest for a circuit board. Said base plate being located at an upper edge of the side wall. Spring legs are extending from the side wall in the direction to the rest and away from the cap. Said spring legs provided on the cap are having a length adapted to spring biased fixing a circuit board resting on the rest.

Thus, the printed circuit board can be plugged onto the interconnection washer and can be held by the foot plate forming a rest for the circuit board and by the spring legs forming a stud.

In another preferred embodiment, at least one of the interconnection washer is formed by an upper metal ring and a lower metal ring and a metal plate extending from the lower metal ring to the upper metal ring. The metal plate is integrally formed with said upper metal ring and said lower metal ring providing a spring element between the lower metal ring and the upper metal ring. The lower metal ring is mounted on a cell terminal and the upper metal ring is mounted on a circuit board. Preferably, the lower metal ring has the diameter smaller than a diameter of the upper metal ring. Then, the metal plate is helically wound with a diameter increasing from the connection print with a lower metal ring to the connection point with the upper metal ring. Preferably, the metal plate extends from the inner edge of the upper metal ring to the outer edge of the lower metal ring.

Said interconnection washer can be picked and placed and soldered onto a printed circuit board as any other electronic component. Due to the metal plate extending from the lower metal ring to the upper metal ring, the interconnection washer has an elastic compliances in the Z-axis parallel to the axis of the cell terminal that can accommodate with unplanarity of the cell terminals and which does not stress the solder join. The design ensures long term electrical connection between the printed circuit board and the cell electrode terminals.

In a preferred embodiment, a temperature sensor is installed on the metal connection path between the cell terminal and the electronic circuitry. Preferably, the temperature sensor is mounted on the interconnection washer. The temperature sensor is electrically connected to the electronic circuitry provided for monitoring the state of the at least one battery cell connected to the respective metal connection path.

Because of the good thermal conductivity of the copper parts or contacts in between the temperature sensor and the cell terminal, the temperature which is measured in highly reproducible and less sensitive to perturbation induced by e.g. battery cooling system, than current sensing solutions.

The temperature sensor can be very small and surface mountable thus can be picked and placed and soldered on the printed circuit board as other electronic components. Assembly cost is reduced to a minimum. Further, there is no needs for wires nor connector between the temperature sensor and the measuring circuitry. Material cost is also reduced to a minimum.

The temperature sensors are able to measure the temperature of the cells electrodes due to a well defined correlation between the internal temperature of the cell and the metal parts comprising the cell electrode terminals.

Current measurement for a series of the battery cells is preferably performed by use of a shunt. In a preferred storage battery assembly, at least one of the conductive bars provided for connecting cell terminals with each other or with a power line has an integrated shunt.

The invention is further explained by a way of a preferred embodiment with the enclosed drawings. It shows:
- Figure 1: - A perspective view of a storage battery assembly for vehicles;
- Figure 2: - Sectional view of a battery assembly comprising a first embodiment of an interconnection washer;
- Figure 3: - Sectional view of a second embodiment of an interconnection washer clipped onto a printed circuit board;
- Figure 4: - Top view onto the interconnection washer of Figure 3;
- Figure 5: - Top view of a battery assembly comprising a printed circuit board mounted onto a plurality of battery cells;
- Figure 6: - Top view of the battery assembly of figure 5 including conductive bars;
- Figure 7: - Top view of a battery assembly comprising two sections of battery assemblies according to figure 6 connected to each other;
- Figure 8: - Top view of a battery assembly comprising two sections of battery assemblies and a rectangular printed circuit board;
- Figure 9: - Top view of another battery assembly;
- Figure 10: - Top view of still another arrangement of a battery assembly;
- Figure 11: - Perspective view of a third embodiment of an interconnection washer;
- Figure 12: - Perspective view of a battery cell connected to a printed circuit board with the interconnection washer according to figure 11.

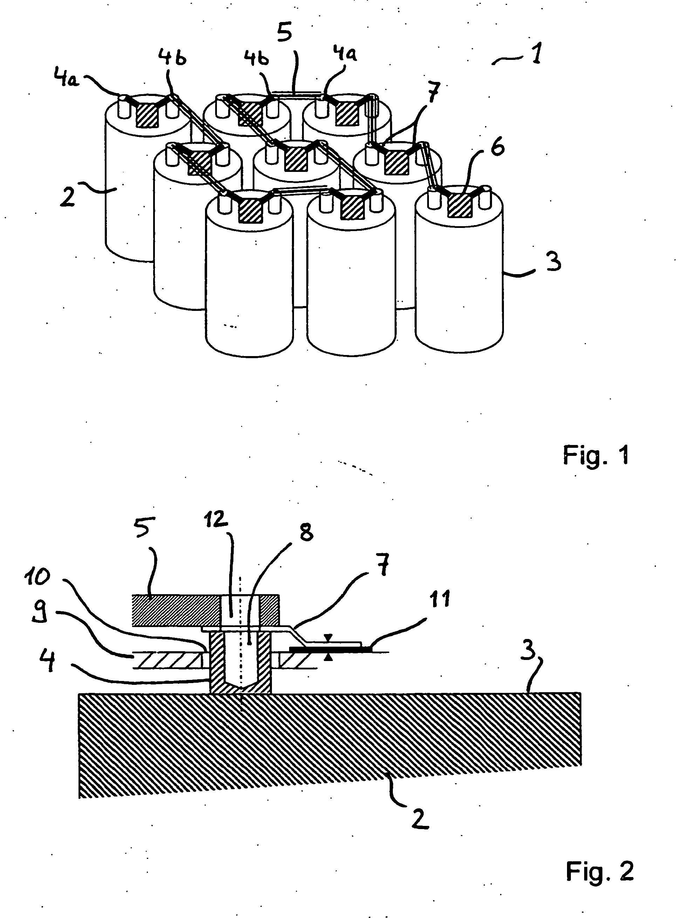

Figure 1 shows a storage battery assembly 1 , which does not form part of the present invention comprising a plurality of battery cells 2 placed side by side of each other. The battery cells 2 each comprises a cylindrical-shaped housing 3 incorporating round electrodes and electrolyte as it is known per se.

Cell terminals 4a, 4b are protruding out of the respective cell housing 3. A first battery terminal is provided for the positive pole and a second cell terminal 4b is provided for the negative pole of the battery cell 2.

The battery cells 2 are connected in series by use of conductive bars 5. The conductive bars 5 each connects a positive cell terminal 4a of a first battery cell 2 and a negative battery terminal 4b of an adjacent battery cell 2.

In order to monitor the state of each of the battery cells 2, a control unit 6 is provided for each of the battery cells 2 and located close by the battery terminals 4a, 4b of a respective battery cell. The control unit 6 comprises a printed circuit board and electronic circuitry provided to monitor and/or control the state and the load-unload cycle of the dedicated battery cell 2. The electronic circuitry can optionally include sensors, like temperature sensors, voltage sensors and/or current sensors, or can be connected to such sensors located separately from the printed circuit board.

The connection of the control unit 6 and the cell terminals 4a, 4b of a respective battery cell 2 is established by means of interconnection washers 7 extending from the battery terminals 4a, 4b to the adjacent located printed circuit board of the control unit 6. The interconnection washers 7 are mounted on the respective cell terminal 4a, 4b together with the dedicated conductive bar 5.

Figure 2 shows a sectional view of a battery cell assembly. The battery cell 2 and the cell terminal 4 extending over the battery housing 3 is clearly visible in said side view. The cell terminal 4 comprises an internal thread 8 being aligned parallel to the longitudinal direction of the cell terminal 4, preferably in the centre of the cell terminal 4.

A printed circuit board 9 carrying electronic circuitry for establishing the control unit 6 is installed on top of the cell housing 3. The printed circuit board 9 comprises an opening in alignment with the cell terminal positions so, that at least one cell terminal 4 extends through the opening 10 of the printed circuit board 9. The printed circuit board 9 carries conductive lines 11 e.g. made from copper, said lines being connected to the electronic circuitry (not shown). An interconnection washer 7 is soldered or welded to a dedicated conductive line 11 on the printed circuit board 9. The embodiment of the interconnection washer 7 shown in figure 2 is formed like a tongue and placed on top of the free end of the cell terminal 4. The interconnection washer 7 is bended downwardly from the top of the respective battery cell 2 in direction to the conductive line 11 of the printed circuit board 9 so as to weld or solder the free end of the interconnection washer 7 to the conductive line 11.

The conductive bar 5 is placed on top of the interconnection washer 7 and the cell terminal 4. Both, the conductive bar 5 and the interconnection washer 7 comprises openings 12 being in alignment with each other and the internal thread 8 of the cell terminal 4 so as to allow a fastening screw extending through the openings 12 into the internal thread 8 and to fasten the conductive bar 5, interconnection washer 7 and cell terminal 4 together.

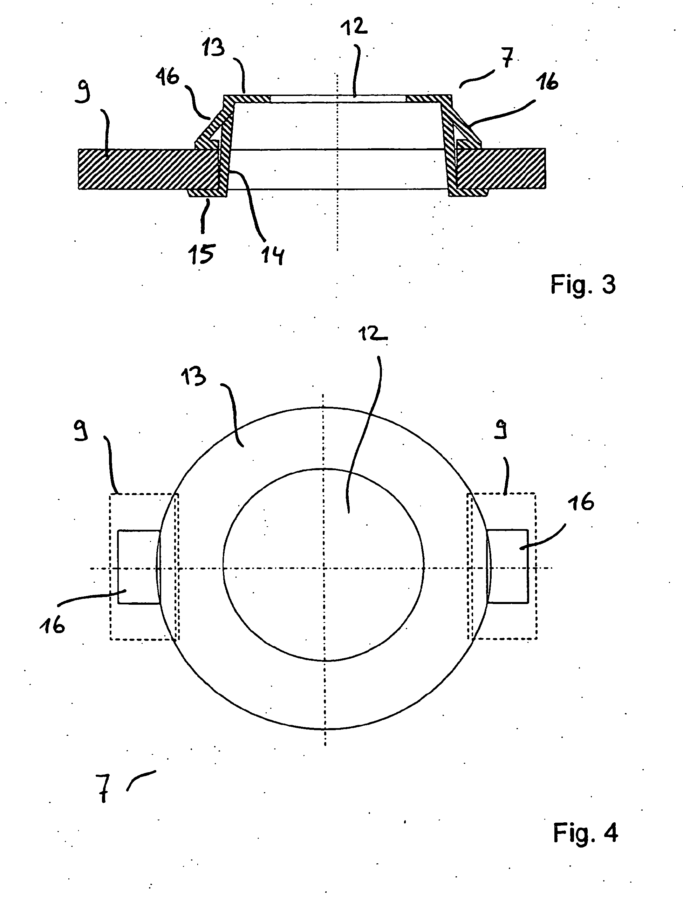

Figure 3 shows a second embodiment of an interconnection washer 7. The interconnection washer 7 has the form of a cap comprising a metal base plate 13. The base plate 13 has the form of a ring comprising the opening 12 for inserting a fastening screw (not shown). A side wall 14 is integrally formed with the base plate 13. The side wall 14 is circumferential surrounding the base plate 13. The base plate 13 is located at the upper edge of the side wall 14. Integrally formed with the lower edge of the side wall 14 is a foot plate 15 having a ring form similar to the base plate 13, but with an increased diameter. The foot plate 15 extends from the side wall 14 to the outside in contrast to the base plate 13 extending from the side wall 14 to the inside of the cap-formed interconnection washer 7. The foot plate 15 forms a rest for a circuit board 9 which is clipped onto the interconnection washer 7 from the side of the base plate 13 into the direction of the foot plate 15.

Spring legs 16 are extending from the side wall 14 in the direction to the printed circuit board 9 and the rest provided by the foot plate 15 and extending away from the cap-formed interconnection washer 7. The length of the spring legs 16, which are folded in the direction of the side wall 14 at their free ends, are adapted to the thickness of the printed circuit board 9 intended to be installed onto the interconnection washer 7 so as to spring biased fixing the circuit board 9 onto the interconnection washer 7.

The printed circuit board 9 is in combination with this embodiment of the interconnection washer 7 preferably rigid, whereas the interconnection board 9 of the first embodiment shown in figure 2 can be rigid or preferably flexible.

Figure 4 shows a top view of the interconnection washer 7 of figure 3.

It should be noted that the interconnection washer 7 is mounted on top of the cell terminal 4 so, that the inner surface of the base plate 13 rests on the free end of the battery cell terminal 4.

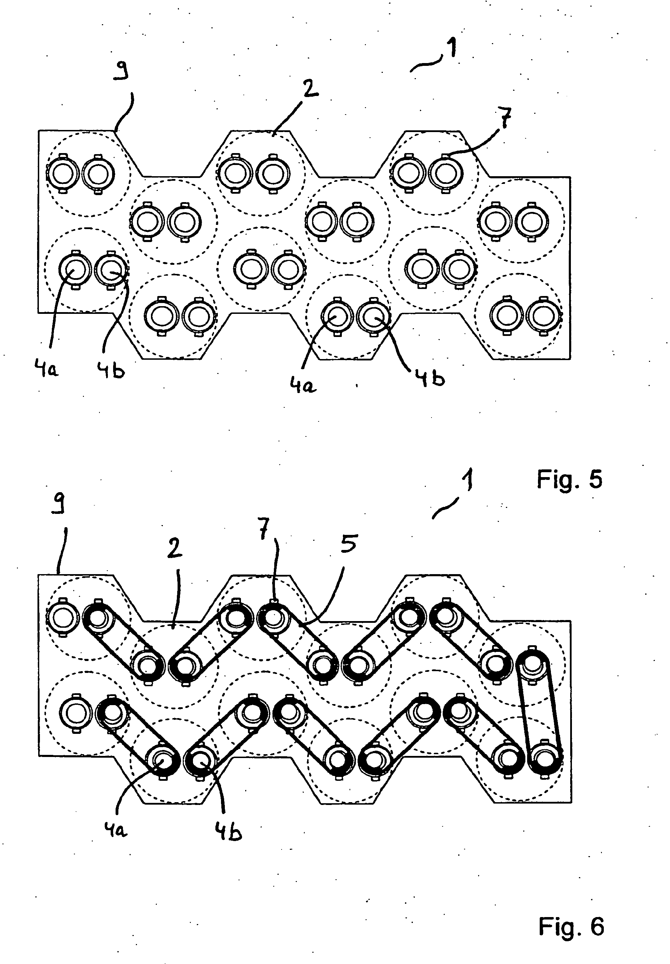

Figure 5 shows a top view of a storage battery assembly comprising a serrated printed circuit board 9 installed on top of a plurality of battery cells 2.

The form of the printed circuit board 9 is adapted to the staggered arrangement of the battery cells 2. The interconnection washers 7 clipped onto the printed circle board 9 are protruding over the upper surface of the printed circuit board 9 and located on top of the free end of the battery cell terminals 4a, 4b.

Figure 6 shows the storage battery assembly 1 of figure 5 with the conductive bars 5 mounted on top of the interconnection washers 7 and the dedicated cell terminals 4a, 4b. The battery cells 2 grouped side by side to each other in a staggered layout are electrically connected in series to each other by use of the conductive bars 5.

The staggered arrangement of the battery cells 2 enhances the package density.

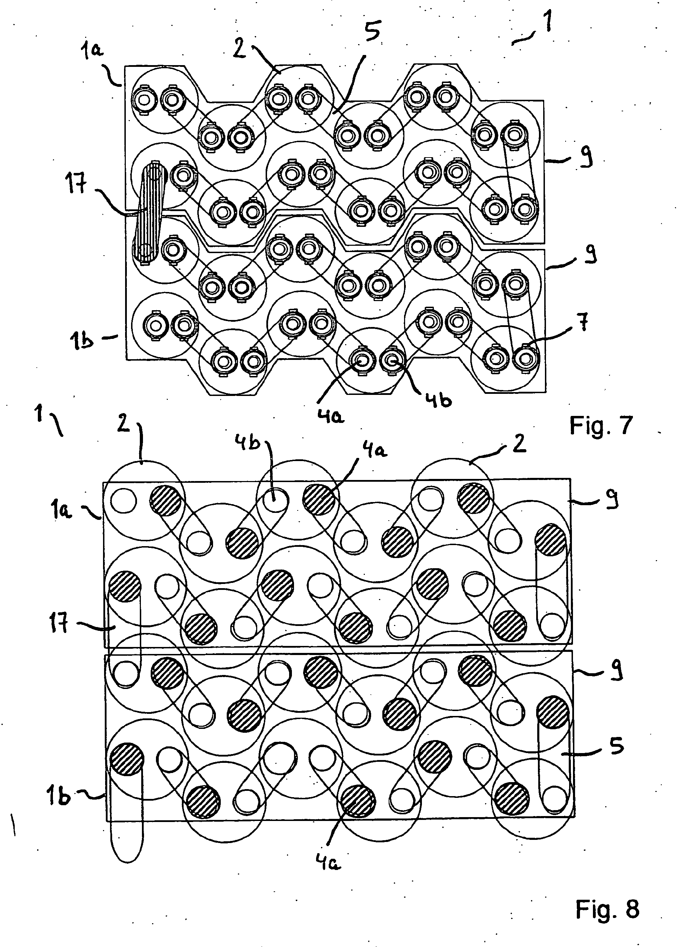

Figure 7 shows a storage battery assembly 1 comprising two sections of battery assemblies 1a, 1b, as shown in figure 6. The serrated design of the printed circuit board 9 has the advantage that two sections of battery assemblies 1a, 1b including the serrated printed circuit boards 9 can be arranged into one another.

The sections of storage battery cell arrangements 1 a, 1 b are electrically connected to each other by use of an interconnection conductive bar 17 similar to the conductive bars 5 of each section 1 a, 1 b.

Figure 8 shows a top view on a similar design according to figure 7. The only difference is the design of the printed circuit boards 9, which are rectangular.

The battery cells 2 are connected to each other with zig-zag course of the conductive bars 5.

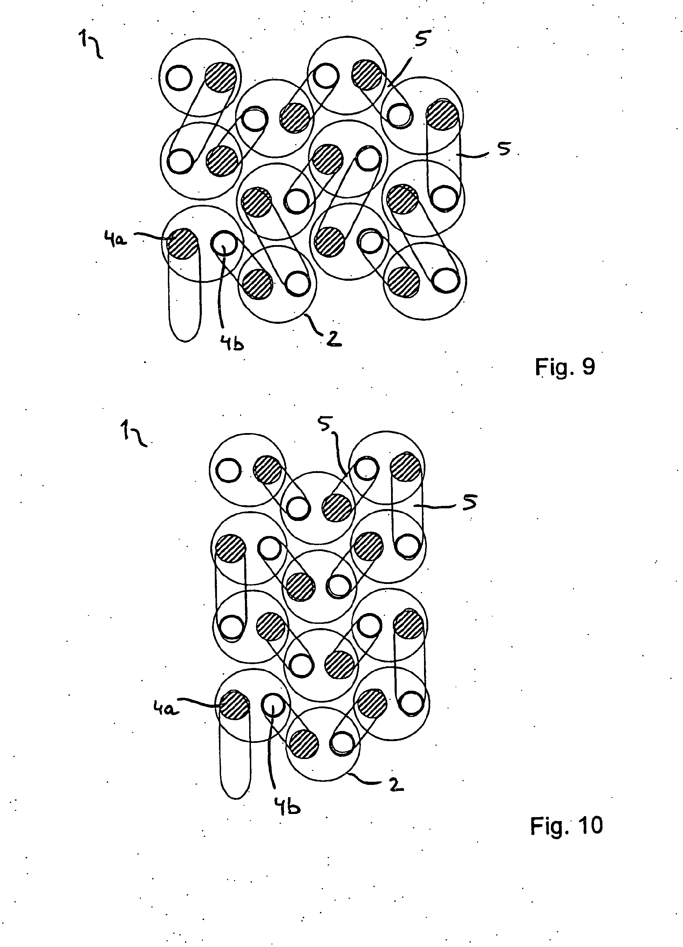

Figure 9 shows a top view onto another embodiment of a storage battery assembly 1. The staggered battery cells 1 are connected to each other with conductive bars of two difference lengths almost unregularly extending in different directions.

Figure 10 shows another embodiment of the storage battery assembly 1 comprising conductive bars 5 of two different length, wherein the longer conductive bars 5 are provided for connecting the outer cell terminals into a first longitudinal direction. The shorter circuit bars 5 are provided for connecting battery terminals 4a, 4b of the adjacent displaced battery cells 2 extending diagonal to the longer conductive bars 5.

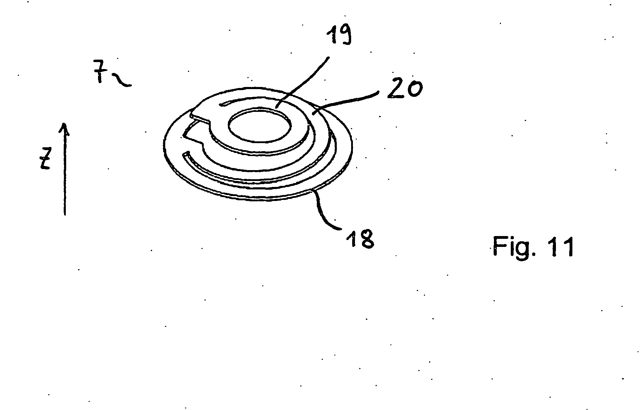

Figure 11 shows a third embodiment of an interconnection washer 7 comprising an upper metal ring 18 and a lower metal ring 19 each having an opening and being in line to each other. The upper and lower metal ring 18, 19 are placed in a distance from each other, said distance being bridged by a metal plate 20 extending from the upper metal ring 18 to the lower metal ring 19.

It should be noted that the interconnection washer 7 is turned upside-down in figure 11 compared to its installation position in order to be able to show the details of the washer.

As can be seen from figure 11, the metal plate 20 extends from the inner edge of the upper metal ring 18 to the outer end edge of the lower metal ring 19 and is helically curved with the diameter increasing from the connection point with the lower metal ring 19 to the connection point with the upper metal ring 18. The lower metal ring 19 has a smaller diameter than the upper metal ring 18.

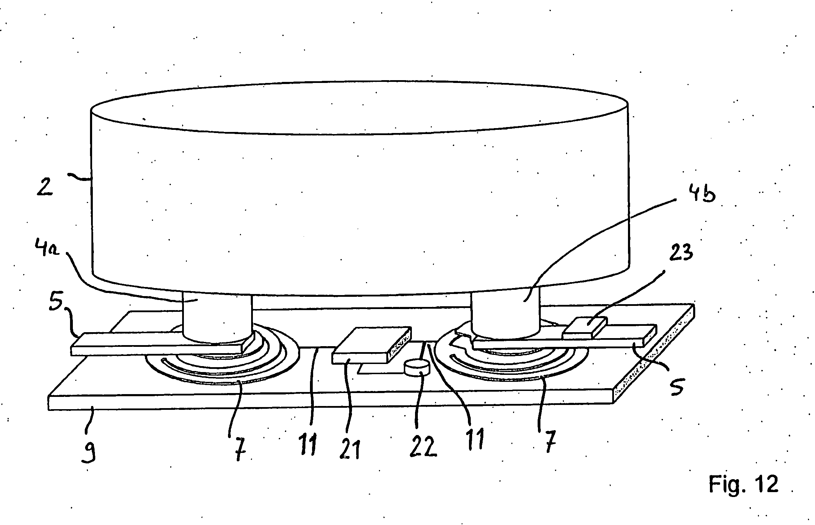

The interconnection washer 7 of figure 11 can be picked and placed and soldered onto a printed circuit board 9 as it is shown in the perspective view of figure 12. Thus, the interconnection washer 7 can be handled as any other electronic component 21 mounted onto the printed circuit board 9.

It should be noted that the arrangement shown in figure 12 which does not belong to the present invention is presented upside down to its two positions.

The interconnection washer 7 has an elastic compliance in the set-axis that can accumulate with unplanarity of the cell electro terminals 4a, 4b and which does not stress the solder join of the interconnection washer 7 and the lines 11 of the printed circuit board 9. Therefore, the interconnection washer 7 ensuring long term electrical connection between the printed circuit board 9 and the cell terminal 4a, 4b.

As can be seen in figure 12, the conductive bars 5 each provided for electrical connecting adjacent battery cells 2 are located between the free end of a cell terminal 4a, 4b and the upper surface of the smaller lower metal ring 19.

Temperature sensors 22 are installed directly on the printed circuit board 9 that performs the temperature measurement. One terminal of the temperature sensor 22 is electrically (and thus thermally) connected to a copper track of the printed circuit board 9 which is turn electrically (and thus thermally) connected to a cell electrode terminal 4a, 4b by means of a connecting device such as an interconnection washer 7 e.g. in form of a spring contact. The voltage at the cell terminal 4b which the temperature sensor 22 is connected to, is the ground reference voltage for the electronic circuitry 21 that performs the temperature measurement. The other terminal of the temperature sensor 22 is connected to the input of the electronic circuitry 21 that performs the temperature measurement.

The advantages of this solution are
- because of the good thermal conductivity of the copper parts or contacts in between the temperature sensor 22 and the cell terminal 4b, the temperature which is measured is much more representative of the cell internal temperature than with current sensing solutions. Moreover, the measurement is much more reproducible and less sensitive to perturbation induced by e.g. battery cooling system, than current sensing solutions.
- the temperature sensors 22 can be very small and surface mountable thus can be picked and placed and soldered on the printed circuit board 9 as other electronic components. Assembly costs are reduced to a minimum.
- there is no needs for wires nor connector between the temperature sensor 22 and the measuring circuitry 21. Material costs is also reduced to a minimum.

The installation of the temperature sensor 22 makes use of the recognition that there is a well define correlation between the internal temperature of the battery cell 2 and the metal parts composing the cell electrode terminals 4a, 4b. Measuring the temperature of such cell terminals 4a, 4b is much more accurate than the one of the ambient air between cells.

For measuring the current that flows in or out the battery assembly, a shunt 23 is provided on at least one conductive bar 5. A shunt 23 offers a good accuracy over a wide range of measurement. The shunt 23 is integrated in one of the copper bars 5 connecting two consecutive cells 2 of the battery string.

The resulting conductive bar 5 is a composite device composed of 3 parts:
- a first copper part, connected to one cell electrode terminal 4b of a given polarity
- a resistive alloy part, i.e. the shunt 23, across which will be measured the voltage drop proportional to the current flowing through it
- a third copper part, connected to the electrode terminal 4a of opposite polarity of the consecutive battery cell 2 in the battery string arrangement.

A preferred embodiment consists in connecting the shunt bar between the battery assembly negative pole and the first battery cell 2 of the battery string, or between the first and the second battery cells 2 of the battery string.

There are many cost advantages for this solution:
- there is no need for additional power wiring between the shunt 23 and the battery terminals 4a, 4b, nor additional bolts and nuts to connect the cables to the shunt 23
- there is no additional component: the shunt 23 is included in one of the conductive connection bars 5 between two consecutive battery cells 2
the connections between each side of the resistive alloy of the shunt 23 and the printed circuit board 9 on which is assembled the electronic circuitry 21 able to measure the voltage drop across the shunt 23 is optimized in terms of length.

In addition, the space and weight required to perform the current measurement are reduced to a minimum, which is a significant advantage considering the compactness and light weight requirements of a battery.

## Claims

1. Storage battery assembly (1) for vehicles comprising:
- a plurality of battery cells (2), each battery cell (2) comprising a closed cell housing (3) and at least one cell terminal (4a, 4b) extending from the cell housing (3),
- electric conductive bars (5, 17) mounted on dedicated cell terminals (4a, 4b), said conductive bars (5, 17) electrically connecting battery cells (2), and
- at least one circuit board (9) comprising electronic circuitry (21) provided for monitoring and/or controlling of battery cells (2),
- cell terminals (4a, 4b) are carrying electrically conductive interconnection washers (7) mounted thereon, wherein said interconnection washers (7) extending to a dedicated circuit board (9) and being connected with electronic circuitry (21) on said respective circuit board, and wherein said circuit board (9) connected to at least one interconnection washer (7) being located adjacent to the at least one cell terminal (4a, 4b) to which the at least one interconnection washer (7) is connected,
**characterized in that** at least one of the circuit boards (9) is located between a respective battery cell housing (3) and conductive bars (5).

2. Storage battery assembly (1) according to claim 1, **characterized in that** the at least one interconnection washer (7) is elastic.

3. Storage battery assembly (1) according to one of the preceding claims, **characterized in that** an insulation layer is provided between the circuit board (9) and the adjacent cell housing (3) and/or an adjacent conductive bar (5).

4. Storage battery assembly (1) according to one of the preceding claims, **characterized in that** at least one of the circuit boards (9) comprising holes (10) corresponding to the location of the cell terminals, wherein said circuit boards (9) being located on battery cells (2) with cell terminals (4a, 4b) extending through respective holes (10) of the circuit board.

5. Storage battery assembly (1) according to one of the preceding claims, **characterized in that** at least one of the circuit boards (9) being placed on top of the at least one of the cell housings (3) with cell terminals (4a, 4b) extending over the at least one circuit board (9), wherein the interconnection washers (7) are mounted to said cell terminals (4a, 4b) having elastic legs of a height being greater than the gap between the upper surface of a circuit board (9) to which the interconnection washer (7) is connected to and the connection position of interconnection washer (7) and the respective cell terminal (4a, 4b), said elastic legs being spring biased to the circuit board (9) when connecting the respective interconnection washer (7) to the dedicated cell terminal (4a, 4b).

6. Storage battery assembly (1) according to one of the preceding claims, **characterized in that** at least one of the circuit boards (9) is flexible.

7. Storage battery assembly (1) according to one of the preceding claims, **characterized in that** at least one of the interconnection washers (7) being welded or soldered to a conductor path (11) on a dedicated circuit board (9).

8. Storage battery assembly (1) according to one of the preceding claims, **characterized in that** the interconnection washers (7) are placed on top of a free end of a dedicated cell terminal (4a, 4b) and that the conductive bars (5) are placed on top of a respective interconnection washer (7), wherein said cell terminals (4a, 4b) are comprising internal threads (8) and said interconnection washers (7) and conductive bars (5) comprising respective openings (12), wherein a cell terminal (4a, 4b), interconnection washer (7) and conductive bar (5) are mounted together by a screw extending through the openings (12) of the conductive bar (5) and the interconnection washer (7) and screwed into the internal thread (8) of the cell terminal (4a, 4b).

9. Storage battery assembly (1) according to one of the preceding **claims, characterized in that** at least one of the interconnection washers (7) is formed by a metal cap comprising a base plate (13), a side wall (14) circumferential surrounding the base plate (13) and a foot plate (15) extending from the side wall (14) to the outside at the lower edge on the opposite side of the base plate (13) forming a rest for a circuit board (9), wherein said base plate (13) being located at an upper edge of the side wall (14) and spring legs (16) extending from the side wall (14) in the direction to the rest and away from the cap are provided on the cap having a length adapted to spring biased fixing the circuit board (9) resting on the rest.

10. Storage battery assembly (1) according to one of the preceding claims, **characterized in that** at least one of the interconnection washers (7) is formed by an upper metal ring (18) and a lower metal ring (19) and a metal plate (20) extending from the lower metal ring (19) to the upper metal ring (18) and integrally formed with said upper metal ring (18) and said lower metal ring (19), wherein said lower metal ring (19) being mounted on a cell terminal (4a, 4b) and said upper metal ring (18) being mounted on a circuit board (9).

11. Storage battery assembly (1) according to claim 10, **characterized in that** said lower metal ring (19) having a diameter smaller than the diameter of the upper metal ring (18), wherein the metal plate (20) being helically curved with a diameter increasing from the connection point with the lower metal ring (19) to the connection point with the upper metal ring (18).

12. Storage battery assembly (1) according to claim 11, **characterized in that** the metal plate (20) extends from the inner edge of the upper metal ring (18) to the outer edge of the lower metal ring (19).

13. Storage battery assembly (1) according to one of the preceding claims **characterized in that** at least one temperature sensor is electrically and thermally coupled to a respective battery cell by connecting a first terminal of the temperature sensor to a conductor path of a dedicated circuit board connected to a cell terminal of the respective battery cell and by connecting a second terminal of the temperature sensor to electronic circuitry provided on said circuit board.

14. Storage battery assembly (1) according to claim 13, **characterized in that** the voltage at the cell terminal to which the first terminal of the temperature sensor is connected forms a ground reference voltage for the electronic circuitry provided for temperature measurement.

15. Storage battery assembly (1) according to claim 13 or 14, **characterized in that** the temperature sensors are surface mountable devices (SMD) placed on the surface on a dedicated circuit board and being soldered to copper tracks provided on the circuit board.

## Patentansprüche

1. Speicherbatterieanordnung (1) für Fahrzeuge, umfassend:
- eine Vielzahl von Batteriezellen (2), wobei jede Batteriezelle (2) ein geschlossenes Zellengehäuse (3) und wenigstens einen Zellenanschluss (4a, 4b) aufweist, der sich vom Zellengehäuse (3) erstreckt,
- elektrisch leitende Stangen (5, 17), die an bestimmten Zellenanschlüssen (4a, 4b) angebracht ist, wobei die leitenden Stangen (5, 17) Batteriezellen (2) elektrisch verbinden, und
- wenigstens eine Leiterplatte (9), umfassend elektronische Schaltungstechnik (21), die zur Überwachung und/oder Steuerung von Batteriezellen (2) vorgesehen ist,
- Zellenanschlüsse (4a, 4b), die elektrisch leitende Verbindungsscheiben (7) tragen, die auf den Zellenanschlüssen angebracht sind, wobei die Verbindungsscheiben (7) sich zu einer bestimmten Leiterplatte (9) erstrecken und mit elektronischer Schaltungstechnik (21) auf der jeweiligen Leiterplatte verbunden sind, und wobei die Leiterplatte (9), die mit wenigstens einer Verbindungsscheibe (7) verbunden ist, benachbart zu dem wenigstens einen Zellenanschluss (4a, 4b) angeordnet ist, mit dem die wenigstens eine Verbindungsscheibe (7) verbunden ist,
**dadurch gekennzeichnet, dass** wenigstens eine der Leiterplatten (9) zwischen einem jeweiligen Batteriezellengehäuse (3) und leitenden Stangen (5) angeordnet ist.

2. Speicherbatterieanordnung (1) nach Anspruch 1, **dadurch gekennzeichnet, dass** die wenigstens eine Verbindungsscheibe (7) elastisch ist.

3. Speicherbatterieanordnung (1) nach einem der vorhergehenden Ansprüche, **dadurch gekennzeichnet, dass** eine Isolationsschicht zwischen der Leiterplatte (9) und dem benachbarten Zellengehäuse (3) und/oder einer benachbarten leitfähigen Stange (5) vorgesehen ist.

4. Speicherbatterieanordnung (1) nach einem der vorhergehenden Ansprüche, **dadurch gekennzeichnet, dass** wenigstens eine der Leiterplatten (9) Löcher (10) entsprechend der Position der Zellenanschlüsse aufweist, wobei die Leiterplatten (9) auf Batteriezellen (2) mit Zellenanschlüssen (4a, 4b) angeordnet sind, die sich durch jeweilige Löcher (10) der Leiterplatte erstrecken.

5. Speicherbatterieanordnung (1) nach einem der vorhergehenden Ansprüche, **dadurch gekennzeichnet, dass** wenigstens eine der Leiterplatten (9) auf der Oberseite des wenigstens einen der Zellengehäuse (3) mit Zellenanschlüssen (4a, 4b) angeordnet ist, die sich über die wenigstens eine Leiterplatte (9) erstrecken, wobei die Verbindungsscheiben (7) an den Zellenanschlüssen (4a, 4b) angebracht sind, die elastische Schenkel mit einer Höhe größer als der Spalt zwischen der oberen Oberfläche einer Leiterplatte (9), mit der die Verbindungsscheibe (7) verbunden ist, und der Verbindungsstelle der Verbindungsscheibe (7) und dem jeweiligen Zellenanschluss (4a, 4b), wobei die elastischen Schenkel zu der Leiterplatte (9) Feder-vorgespannt sind beim Verbinden der jeweiligen Verbindungsscheibe (7) mit dem bestimmten Zellenanschluss (4a, 4b).

6. Speicherbatterieanordnung (1) nach einem der vorhergehenden Ansprüche, **dadurch gekennzeichnet, dass** wenigstens eine der Leiterplatten (9) flexibel ist.

7. Speicherbatterieanordnung (1) nach einem der vorhergehenden Ansprüche, **dadurch gekennzeichnet, dass** wenigstens eine der Verbindungsscheiben (7) an einer Leiterbahn (11) auf einer bestimmten Leiterplatte (9) angeschweißt oder angelötet ist.

8. Speicherbatterieanordnung (1) nach einem der vorhergehenden Ansprüche, **dadurch gekennzeichnet, dass** die Verbindungsscheiben (7) auf der Oberseite eines freien Endes eines bestimmten Zellenanschlusses (4a, 4b) angeordnet sind und dass die leitenden Stangen (5) auf der Oberseite einer jeweiligen Verbindungsscheibe (7) angeordnet sind, wobei die Zellenanschlüsse (4a, 4b) Innengewinde (8) aufweisen und die Verbindungsscheiben (7) und leitenden Stangen (5) jeweilige Öffnungen (12) aufweisen, wobei ein Zellenanschluss (4a, 4b), eine Verbindungsscheibe (7) und eine leitende Stange (5) durch eine Schraube zusammen montiert sind, die sich durch die Öffnungen (12) der leitenden Stange (5) und der Verbindungsscheibe (7) erstreckt und in das Innengewinde (8) des Zellenanschlusses (4a, 4b) geschraubt ist.

9. Speicherbatterieanordnung (1) nach einem der vorhergehenden Ansprüche, **dadurch gekennzeichnet, dass** wenigstens eine der Verbindungsscheiben (7) durch eine Metallkappe gebildet ist, die eine Grundplatte (13), eine Seitenwand (14), die die Grundplatte (13) in Umfangsrichtung umgibt, und eine Fußplatte (15) aufweist, die sich von der Seitenwand (14) nach außen am unteren Rand auf der gegenüberliegenden Seite der Grundplatte (13) erstreckt und eine Auflage für eine Leiterplatte (9) bildet, wobei die Grundplatte (13) an einer oberen Kante der Seitenwand (14) angeordnet ist und Federschenkel (16) an der Kappe vorgesehen sind, die sich von der Seitenwand (14) in Richtung zu der Auflage und weg von der Kappe erstrecken und die eine Länge haben, dass sie geeignet sind, die an der Auflage aufliegende Leiterplatte (9) Feder-vorgespannt zu fixieren.

10. Speicherbatterieanordnung (1) nach einem der vorhergehenden Ansprüche, **dadurch gekennzeichnet, dass** wenigstens eine der Verbindungsscheiben (7) durch einen oberen Metallring (18) und einen unteren Metallring (19) und eine Metallplatte (20), die sich von dem unteren Metallring (19) zu dem oberen Metallring (18) erstreckt und integral mit dem oberen Metallring (18) und dem unteren Metallring (19) gebildet ist, gebildet ist, wobei der untere Metallring (19) an einem Zellenanschluss (4a, 4b) angebracht ist und der obere Metallring (18) an einer Leiterplatte (9) angebracht ist.

11. Speicherbatterieanordnung (1) nach Anspruch 10, **dadurch gekennzeichnet, dass** der untere Metallring (19) einen kleineren Durchmesser hat als der obere Metallring (18), wobei die Metallplatte (20) schraubenförmig gekrümmt mit einem Durchmesser ausgebildet ist, der vom Verbindungspunkt mit dem unteren Metallring (19) zu dem Verbindungspunkt mit dem oberen Metallring (18) größer wird.

12. Speicherbatterieanordnung (1) nach Anspruch 11, **dadurch gekennzeichnet, dass** die Metallplatte (20) sich von der inneren Kante des oberen Metallrings (18) zu dem äußeren Rand des unteren Metallrings (19) erstreckt.

13. Speicherbatterieanordnung (1) nach einem der vorhergehenden Ansprüche, **dadurch gekennzeichnet, dass** wenigstens ein Temperatursensor elektrisch und thermisch mit einer jeweiligen Batteriezelle durch Verbinden eines ersten Anschlusses des Temperatursensors mit einer Leiterbahn einer bestimmten Leiterplatte, die mit einem Zellenanschluss der jeweiligen Batteriezelle verbunden ist, und durch Verbinden eines zweiten Anschlusses des Temperatursensors mit elektronischer Schaltungstechnik, die auf der Leiterplatte vorgesehen ist, gekoppelt ist.

14. Speicherbatterieanordnung (1) nach Anspruch 13, **dadurch gekennzeichnet, dass** die Spannung an dem Zellenanschluss, mit dem der erste Anschluss des Temperatursensors verbunden ist, eine Massereferenzspannung für die elektronische Schaltungstechnik, die zur Temperaturmessung vorgesehen ist, bildet.

15. Speicherbatterieanordnung (1) nach Anspruch 13 oder 14, **dadurch gekennzeichnet, dass** die Temperatursensoren oberflächenmontierbare Bauelemente (SMD) sind, die auf der Oberfläche auf einer bestimmten Leiterplatte angeordnet und an Kupferbahnen auf der Leiterplatte gelötet sind.

## Revendications

1. Ensemble batterie d'accumulateurs (1) pour véhicules comprenant :
une pluralité d'éléments (2) de batterie, chaque élément (2) de batterie comprenant un boîtier fermé (3) d'élément et au moins une borne (4a, 4b) d'élément s'étendant à partir du boîtier (3) d'élément ;
des barres (5, 17) électroconductrices montées sur des bornes (4a, 4b) d'élément dédiées, lesdites barres (5, 17) conductrices raccordant électriquement les éléments (2) de batterie ; et
au moins une carte de circuit imprimé (9) comprenant une circuiterie électronique (21) mise en place pour surveiller et/ou commander les éléments (2) de batterie,
les bornes (4a, 4b) d'élément portant des rondelles d'interconnexion (7) électroconductrices montées sur elles, dans lequel lesdites rondelles d'interconnexion (7) s'étendent jusqu'à une carte de circuit imprimé (9) dédiée et sont raccordées à la circuiterie électronique (21) sur ladite carte de circuit imprimé correspondante et dans lequel ladite carte de circuit imprimé (9) raccordée à au moins une rondelle d'interconnexion (7) est située tout à côté de ladite borne (4a, 4b) d'élément à laquelle est raccordée ladite rondelle d'interconnexion (7),
**caractérisé en ce qu'**au moins une des cartes de circuit imprimé (9) est située entre le boîtier (3) d'élément de batterie correspondant et les barres conductrices (5).

2. Ensemble batterie d'accumulateurs (1) selon la revendication 1, **caractérisé en ce que** ladite rondelle d'interconnexion (7) est élastique.

3. Ensemble batterie d'accumulateurs (1) selon l'une quelconque des revendications précédentes, **caractérisé en ce qu'**une couche d'isolation est disposée entre la carte de circuit imprimé (9) et le boîtier (3) d'élément adjacent et/ou une barre conductrice (5) adjacente.

4. Ensemble batterie d'accumulateurs (1) selon l'une quelconque des revendications précédentes, **caractérisé en ce qu'**au moins une des cartes de circuit imprimé (9) comprend des trous (10) correspondant à l'emplacement des bornes d'élément, dans lequel lesdites cartes de circuit imprimé (9) sont situées sur les éléments (2) de batterie avec les bornes (4a, 4b) d'élément qui traversent les trous (10) correspondants de la carte de circuit imprimé.

5. Ensemble batterie d'accumulateurs (1) selon l'une quelconque des revendications précédentes, **caractérisé en ce qu'**au moins une des cartes de circuit imprimé (9) est placée sur ledit boîtier (3) d'élément avec les bornes (4a, 4b) d'élément qui s'étendent au-dessus de ladite carte de circuit imprimé (9), dans lequel les rondelles d'interconnexion (7) sont montées sur lesdites bornes (4a, 4b) d'élément en ayant des pattes élastiques dont la hauteur est supérieure à l'intervalle entre la surface supérieure de la carte de circuit imprimé (9) à laquelle la rondelle d'interconnexion (7) est raccordée et la position de raccordement de la rondelle d'interconnexion (7) à la borne (4a, 4b) d'élément correspondante, lesdites pattes élastiques étant rappelées par effet ressort vers la carte de circuit imprimé (9) quand on raccorde la rondelle d'interconnexion (7) correspondante à la borne (4a, 4b) d'élément dédiée.

6. Ensemble batterie d'accumulateurs (1) selon l'une quelconque des revendications précédentes, **caractérisé en ce qu'**au moins une des cartes de circuit imprimé (9) est flexible.

7. Ensemble batterie d'accumulateurs (1) selon l'une quelconque des revendications précédentes, **caractérisé en ce qu'**au moins une des rondelles d'interconnexion (7) est soudée ou brasée à une piste conductrice (11) sur une carte de circuit imprimé (9) dédiée.

8. Ensemble batterie d'accumulateurs (1) selon l'une quelconque des revendications précédentes, **caractérisé en ce que** les rondelles d'interconnexion (7) sont placées sur une extrémité libre d'une borne (4a, 4b) d'élément dédiée et **en ce que** les barres conductrices (5) sont placées sur une rondelle d'interconnexion (7) correspondante, dans lequel lesdites bornes (4a, 4b) d'élément comprennent des filetages intérieurs (8) et lesdites rondelles d'interconnexion (7) et les barres conductrices (5) comprennent des ouvertures (12) correspondantes, dans lequel une borne (4a, 4b) d'élément, une rondelle d'interconnexion (7) et une barre conductrice (5) sont assemblées par une vis qui traverse les ouvertures (12) de la barre conductrice (5) et de la rondelle d'interconnexion (7) et se visse dans le filetage intérieur (8) de la borne (4a, 4b) d'élément.

9. Ensemble batterie d'accumulateurs (1) selon l'une quelconque des revendications précédentes, **caractérisé en ce qu'**au moins une des rondelles d'interconnexion (7) est constituée par une coiffe métallique comprenant une plaque d'appui (13), une paroi latérale (14) circonférentielle entourant la plaque d'appui (13) et une plaque de pied (15) s'étendant depuis la paroi latérale (14) vers l'extérieur au niveau du bord inférieur, du côté opposé à la plaque d'appui (13), et constituant un support pour la carte de circuit imprimé (9), dans lequel ladite plaque d'appui (13) est située au bord supérieur de la paroi latérale (14) et des pattes à ressort (16) s'étendant depuis la paroi latérale (14) dans la direction du support et en s'écartant de la coiffe sont disposées sur la coiffe avec une longueur apte à fixer, par un rappel à ressort, la carte de circuit imprimé (9) reposant sur le support.

10. Ensemble batterie d'accumulateurs (1) selon l'une quelconque des revendications précédentes, **caractérisé en ce qu'**au moins une des rondelles d'interconnexion (7) est constituée par un anneau métallique supérieur (18), un anneau métallique inférieur (19) et une plaque métallique (20) s'étendant de l'anneau métallique inférieur (19) à l'anneau métallique supérieur (18) et formée d'une seule pièce avec ledit anneau métallique supérieur (18) et ledit anneau métallique inférieur (19), dans lequel ledit anneau métallique inférieur (19) se monte sur une borne (4a, 4b) d'élément et ledit anneau métallique supérieur (18) se monte sur une carte de circuit imprimé (9).

11. Ensemble batterie d'accumulateurs (1) selon la revendication 10, **caractérisé en ce que** ledit anneau métallique inférieur (19) a un diamètre plus faible que le diamètre de l'anneau métallique supérieur (18), dans lequel la plaque métallique (20) est courbée en hélice avec un diamètre croissant du point de jonction avec l'anneau métallique inférieur (19) au point de jonction avec l'anneau métallique supérieur (18).

12. Ensemble batterie d'accumulateurs (1) selon la revendication 11, **caractérisé en ce que** la plaque métallique (20) s'étend du bord intérieur de l'anneau métallique supérieur (18) au bord extérieur de l'anneau métallique inférieur (19).

13. Ensemble batterie d'accumulateurs (1) selon l'une quelconque des revendications précédentes, **caractérisé en ce qu'**au moins une sonde de température est accouplée électriquement et thermiquement à un élément de batterie correspondant en raccordant une première borne de la sonde de température à une piste conductrice d'une carte de circuit imprimé dédiée raccordée à une borne d'élément de l'élément de batterie correspondant et en raccordant la seconde borne de la sonde de température à une circuiterie électronique disposée sur ladite carte de circuit imprimé.

14. Ensemble batterie d'accumulateurs (1) selon la revendication 13, **caractérisé en ce que** la tension à la borne d'élément à laquelle la première borne de la sonde de température est raccordée constitue une tension de référence de terre pour la circuiterie électronique prévue pour la mesure des températures.

15. Ensemble batterie d'accumulateurs (1) selon la revendication 13 ou 14, **caractérisé en ce que** les sondes de température sont des composants montés en surface (CMS) placés en surface sur une carte de circuit imprimé dédiée et brasés aux pistes en cuivre sur la carte de circuit imprimé.
